Europäisches Patentamt

European Patent Office

Office européen des brevets

(11) Veröffentlichungsnummer: **0 280 176**
**A1**

# (12) EUROPÄISCHE PATENTANMELDUNG

(21) Anmeldenummer: 88102310.5

(22) Anmeldetag: 17.02.88

(51) Int. Cl.⁴ **H01L 27/02** , H01L 23/52

(30) Priorität: 27.02.87 DE 3706462

(43) Veröffentlichungstag der Anmeldung:
3+.08.88 Patentblatt 88/35

(84) Benannte Vertragsstaaten:
DE FR GB IT SE

(71) Anmelder: **Siemens Aktiengesellschaft Berlin und München**
**Wittelsbacherplatz 2**
**D-8000 München 2(DE)**

(72) Erfinder: **Michel, Petra, Dipl.-Phys.**
**Vogelherd 1**
**D-8018 Grafing(DE)**
Erfinder: **Geiger, Martin, Dipl.-Ing.**
**Pöttingerstrasse 11**
**D-8024 Furth(DE)**

(54) **Grundzelle für eine Gate Array.**

(57) Die Gate Array Anordnung sieht in einem Kernbereich Grundzellen vor, durch deren Verdrahtung logische Funktionen oder speichernde Funktionen realisiert werden können. Die Grundzellen bestehen aus sechs oder sieben Transistoren in CMOS-Technik. Drei P-Kanaltransistoren (TR1) liegen in einem ersten Bereich (BE1), drei N-Kanaltransistoren (TR2) liegen in einem zweiten Bereich (BE2). Die Anschlüsse (GTA) der Gateelektroden (GT1, GT2) der Transistoren sind zwischen den beiden Bereichen (BE1, BE2) angeordnet. Außerhalb des Bereiches (BE2) für die N-Kanaltransistoren (TR2) ist ein weiterer Transistor (TR3) angeordnet, der eine kleinere Kanalweite hat als die übrigen Transistoren (TR1, TR2). Die Gateelektrode (GT3) liegt parallel zu den Gateelektroden (GT2) der N Kanaltransistoren (TR2), ist jedoch kürzer. Der Anschluß (GTB) der Gateelektrode (GT3) des Transistors (TR3) ist der Leitung für die Versorgungspanung (VSS) zugewendet. Das Lay Out der Grundzelle hat den Vorteil, daß die Anschlüsse (GTA) der Gateelektroden der N-Kanal-bzw. P-Kanaltransistoren benachbart zueinander liegen und somit auf kürzestem Weg miteinander verbunden werden können. Andererseits bleibt über den Bereichen (BE1, BE2) genügend Raum, um Verdrahtungsleitungen über die Zelle hinweg zu führen.

FIG 2

## Grundzelle für eine Gate Array Anordnung in CMOS Technik

Die Erfindung bezieht sich auf eine Grundzelle für ein Gate Array Anordnung in CMOS Technik, bei der erste Transistoren des einen Leitungstyps in einem ersten Bereich hintereinanderliegen und gleich viele zweite Transistoren des anderen Leitungstyps in einem zweiten zum ersten Bereich benachbart angeordneten Bereich hintereinanderliegen und bei der die Elektroden der Transistoren im ersten Bereich und die Elektroden der Transistoren im zweiten Bereich jeweils in einer Richtung verlaufen.

Gate Array Anordnungen sind bekannt (z.B. Hitachi Review Vol. 33 (1984) Nr. 5, S. 261 bis 266, EP 0119059-A2). Bei solchen Gate Array Anordnungen werden auf einem Chip Zellbereiche oder Zellen in bestimmter Anordnung vorgesehen, auf denen Grundzellen realisiert sind. Ein Beispiel einer solchen Gate Array Anordnung zeigt Fig. 1 und Fig. 2 der EP 011 9059-A2. Die Grundzellen bestehen aus N-Kanal und P-Kanaltransistoren, die in bestimmter Weise in den Zellbereichen angeordnet sind. Durch Verbinden .der N-und P-Kanaltransistoren pro Grundzelle kann die Grundzelle zur Realisierung einer Grundfunktion spezifiziert werden und ihr z.B. eine logische Funktion oder eine Speicherfunktion gegeben werden. Aus Hitachi Review, die oben zitiert worden ist, ergibt sich, daß eine Grundzelle z.B. aus 10 Transistoren bestehen kann, die so miteinander verbunden werden, daß eine RAM-Speicherzelle mit einem Eingang oder zwei Eingängen entsteht. Durch andere Verbindungen der Transistoren in einer Grundzelle kann z.B. eine logische Funktion, z.B. eine NAND-Funktion realisiert werden.

Aus der EP 0119059-A2 ergeben sich Grundzellen aus vier Transistoren, jeweils zwei P-Kanal und zwei N-Kanal Transi storen. In dieser Literaturstelle ist gezeigt, wie durch Zusammenschaltung der Grundzellen logische Funktionen realisiert werden können.

Die einzelnen Grundzellen in der Gate Array Anordnung müssen zur Einstellung von Funktionen miteinander verbunden werden. Dies geschieht dann über Verdrahtungskanäle, die entweder zwischen den Zeilen aus Grundzellen angeordnnet werden oder die über die Zeilen aus Grundzellen verlaufen.

Die Realisierung von Speichern unterschiedlicher Kapazität wurde bisher auf verschiedene Art erreicht. Für speichernde Strukturen kleiner Kapazität wurden bistabile Schaltungen verwendet. Diese sind aus mehreren Gattern zusammengesetzt und benötigen deshalb verhältnismäßig viele Grundzellen eines Gate Arrays zur Speicherung einer Informationseinheit.

Speicher großer Kapazität wurden dadurch realisiert, daß ein als allgemeine Zelle entworfener Speicherblock definierter Kapazität in den Kernbereich eines Chips eingebaut wurde. Dies führte dazu, daß die Kapazität eines Speichers nur in Schritten der Speicherkapazität dieser allgemeinen Zelle, auch Makrozelle genannt, gewählt werden kann und mehrere verschiedene Gate-Array-Master entsprechend der verschieden großen Speicherbereiche erzeugt werden mußten. Schließlich war der Platzbedarf für solche Speicher verhältnismäßig groß, da Verdrahtungskanäle zwischen den Zeilen von Grundzellen angeordnet werden mußten.

Die der Erfindung zugrundeliegende Aufgabe besteht darin, eine Grundzelle für eine Gate Array Anordnung in CMOS Technik anzugeben, die so aufgebaut ist, daß neben logischen Grundfunktionen auch Speicherfunktionen realisiert werden können, so daß es möglich ist, die Speicherbereiche auf einer Gate Array Anordnung flexibel an den jeweiligen Bedarf anzupassen.

Diese Aufgabe wird bei einer Grundzelle der eingangs angegebenen Art durch die im Kennzeichen des Anspruchs 1 angegebenen Merkmale gelöst.

Die Grundzelle aus 3 P Kanal und 3 N Kanaltransistoren, die gemäß dem Anspruch 1 realisiert ist, hat den Vorteil, daß die Anschlüsse für die Gateelektroden im mittleren Bereich der Grundzelle liegen und somit Platz für Verdrahtungsleitungen oder Verdrahtungskanäle in den äußeren Bereichen vorhanden ist.

Besonders vorteilhaft ist es, wenn die Grundzelle auf sieben Transistoren besteht, und zwar jeweils 3 P Kanaltransistoren und 3 N Kanaltransistoren gleicher Kanalweite und aus einem N-Kanaltransistor kleinerer Kanalweite. Mit einer solchen Grundzelle ist die Realisierung einer Speicherzelle möglich, die für die Speicherzelle sechs Transistoren verwendet und für einen Ansteuertransistor den Transistor mit der kleinen Kanalweite.

Mit Hilfe solcher Grundzellen kann eine Gate Array Anordnung aufgebaut werden, die im Kernbereich Grundzellen vorsieht, um den Kernbereich aus Grundzellen Platz für Verdrahtungskanäle vorsieht und die um die Verdrahtungskanäle herum einen Randstreifen für Randzellen und Versorgungsleitungen vorsieht. Die Versorgungsleitungen werden dabei um den Kernbereich herumgelegt und über im Randstreifen liegende Randzellen angeordnet. Damit ist es möglich, die Verbindung zwischen den Versorgungsleitungen und den Randzellen auf kürzestem Weg zu erreichen und die Versorgungsleitungen des Kernbereiches von zwei Seiten anzuschließen.

Andere Weiterbildungen der Erfindung ergeben sich aus den Unteransprüchen.

Anhand von Ausführungsbeispielen, die in den Figuren dargestellt sind, wird die Erfindung weiter erläutert. Es zeigen

Fig. 1 ein Schaltbild einer Grundzelle,

Fig. 2 ein LayOut einer Grundzelle,

Fig. 3 einen Schnitt durch eine Grundzelle,

Fig. 4 eine prinzipielle Anordnung der Grundzellen eines Gate Arrays,

Fig. 5 einen Ausschnitt aus dem LayOut eines Gate Array,

Fig. 6 die Anordnung der Versorgungsleitungen auf dem Gate Array.

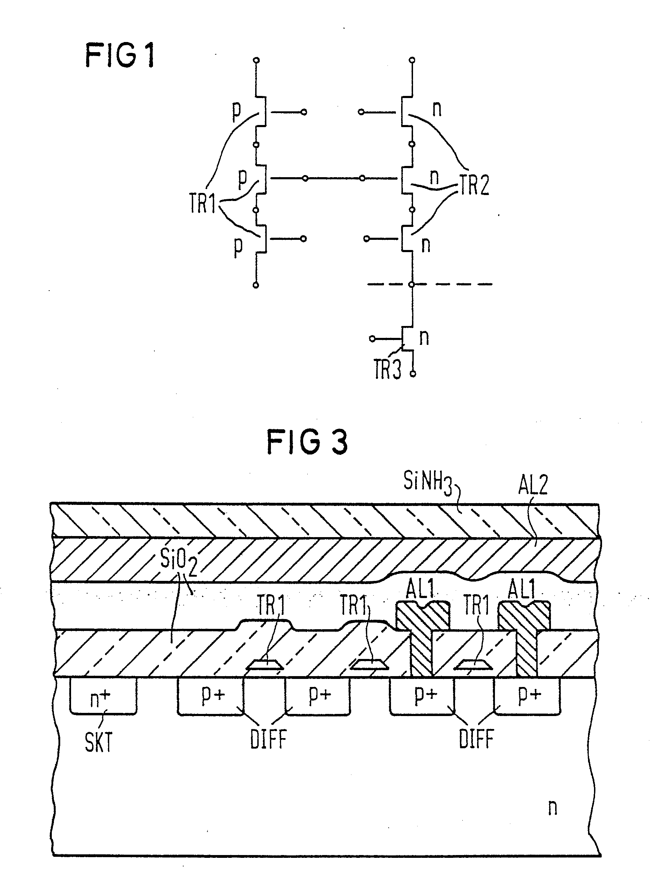

Aus Fig. 1 ergibt sich ein Schaltbild der Grundzelle. Die Grundzelle besteht in einer ersten Ausführungsform aus sechs Transistoren, nämlich 3 P-Kanaltransistoren TR1 und 3 N-Kanaltransistoren TR2. Die N-Kanaltransistoren und die P-Kanaltransistoren sind jeweils mit ihren gesteuerten Strecken in Serie geschaltet. Die Gate Elektrode eines P-Kanaltransistors und eines N-Kanaltransistors sind miteinander verbunden.

In einem zweiten Ausführungsbeispiel besteht die Grundzelle aus sieben Transistoren, nämlich 3 P-Kanaltransistoren TR1, 3 N-Kanaltransistoren TR2 und einem weiteren N-Kanaltransistor TR3. Der weitere N-Kanaltransistor TR3 liegt mit seiner gesteuerten Strecke in Serie zu den gesteuerten Strekken der anderen N-Kanaltransistoren TR2.

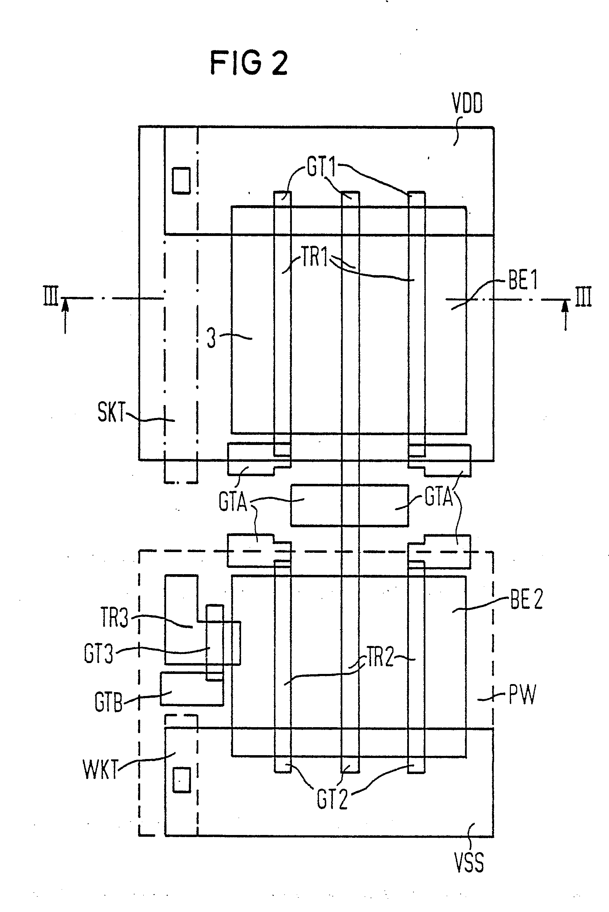

Das LayOut der Grundzelle zeigt Fig. 2. Die Grundzelle enthält zunächst einen Bereich BE1, in dem die P-Kanaltransistoren TR1 angeordnet sind und einen zweiten Bereich BE2, in dem die N-Kanaltransistoren angeordnet sind. Dabei sind die P-Kanaltransistoren TR1 zueinander so angeordnet, daß sie entsprechend Fig. 1 hintereinander liegen. Die Gateelektroden GT1 laufen parallel zueinander. Entsprechendes gilt für die N-Kanaltransistoren im Bereich BE2. Hier verlaufen die Gateelektroden GT2 parallel zueinander. Der Bereich BE1 für die P-Kanaltransistoren TR1 und der Bereich BE2 für die N-Kanaltransistoren TR2 sind benachbart zueinander so angeordnet, daß die Elektroden jeweils in einer Richtung verlaufen. Dabei sind die Anschlüsse GTA der Gateelektroden GT1 und GT2 zwischen den Bereichen BE1 und BE2 angeordnet oder liegen in den einander zugekehrten Rändern der Bereiche BE1 und BE2. Diese Anordnung der Anschlüsse GTA für die Gateelektroden GT1, GT2 hat den Vorteil, daß die Verbindung der Gateelektroden miteinander auf kürzestem Weg erfolgt, weiterhin ein großer Teil der Bereiche BE1, BE2 frei bleibt von Anschlüssen für die Gateelektroden und somit Raum für Verdrahtungskanäle über der Grundzelle vorhanden ist.

An den voneinander abgekehrten Rändern der Bereiche BE1 und BE2 sind Leitungen für die Versorgungspotentiale VDD und VSS angeordnet. Weiterhin ist jeweils ein Substratkontakt SKT, der mit dem Potential VDD verbunden ist und ein Wannenkontakt WKT, der mit VSS verbunden ist, vorgesehen. Schließlich ist in der Fig. 2 noch die P-Wanne PW für die N-Kanaltransistoren TR2 angedeutet.

Die bisher beschriebene Grundzelle aus drei P Kanal-und drei N Kanaltransistoren kann gemäß Fig. 2 um einen weiteren N-Kanaltransistor TR3 erweitert werden. Dieser N-Kanaltransistor TR3 liegt außerhalb des Bereiches BE2 für die N-Kanaltranistoren TR2. Er liegt im Vergleich zu den Transistoren TR2 im Bereich BE2 so, daß seine Gateelektrode GT3 und der Anschluß GTB für die Gateleketrode GT3 nahe zur Leitung für das Potential VSS angeordnet ist. Damit ist eine Verbindung mit dem Potential VSS auf kürzestem Wege möglich, was dann häufig vorkommt, wenn pro Grundzelle nur sechs Transistoren für die Realisierung einer Funktion erforderlich sind. Dann kann der Transistor TR3 stillgelegt werden. Durch die Anordnung des weiteren Transistors TR3 zu den Transistoren TR2 bleibt wei terhin Platz für Verdrahtungskanäle über dem Bereich BE2 vorhanden.

Aus Fig. 2 ist zu sehen, daß die Kanalweiten der P-Kanaltransistoren TR1 und der N-Kanaltransistoren TR2 größer sind als die Kanalweite des weiteren N-Kanaltransistors TR3. Ein wesentlicher Vorteil dieser Lösung ist, daß mit ihr Speicherzellen aus sieben Transistoren realisiert werden können, jedoch die für die Grundzelle erforderliche Fläche durch den siebten Transistor TR3 nicht vergrößert wird.

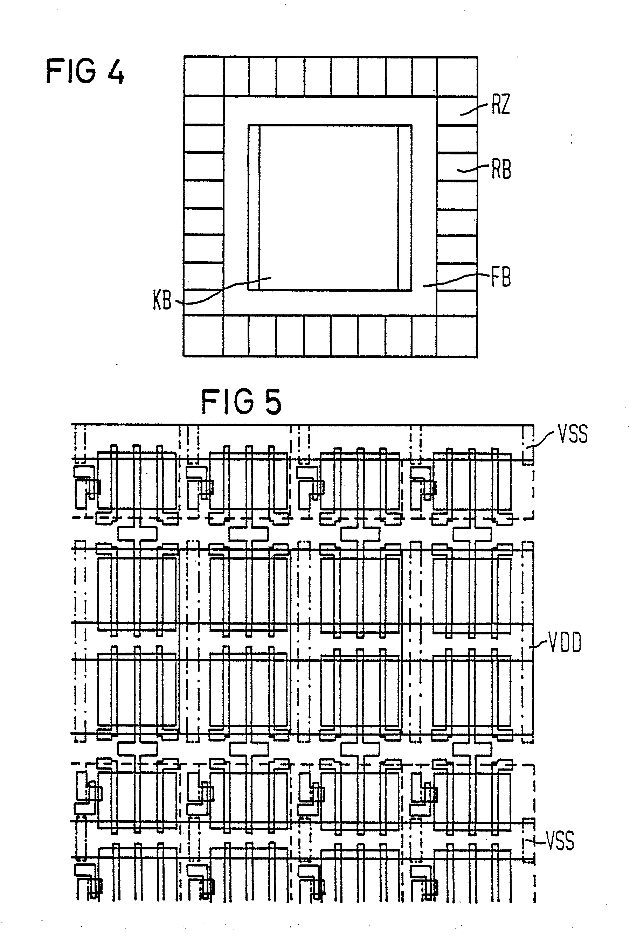

Fig. 3 zeigt einen Schnitt durch die Grundzelle an der Stelle 3-3. In einem n-Substrat SU sind Diffusionsgebiete DIFF für die P-Kanaltransistoren angeordnet. Im Oxid $SiO_2$ liegen die Gateelektroden GT1 der P Kanaltransistoren TR1. Gestrichelt und beispielsweise ist gezeigt, wie zwei Diffusionsgebiete DIFF mit einer Leitung aus Aluminium AL1 verbunden sein können, um Source oder Drain eines Transistors anzuschließen. Weiterhin ist beispielhaft gezeigt, wie über einer Isolierebene $SiO_2$ eine zweite Leiterbahn AL2 aus Aluminium angeordnet sein kann. Über dem ganzen kann eine Schicht aus $SiNO_3$ zur Isolation gelegt sein. Der in Fig. 3 gezeigte Aufbau ist bekannt und braucht nicht weiter erläutert zu werden.

Eine Gate Array Anordnung unter Verwendung der Grundzellen der Fig. 2 kann Fig. 4 entnommen werden. Die Grundzellen sind in einem Kernbereich KB angeordnet. Ein mögliches LayOut dieses Kernbereiches KB zeigt Fig. 5. Um den Kernbereich KB aus Grundzellen ist ein Bereich FB herumgelegt, in dem Verdrahtungskanäle angeordnet sein können. Dieser Bereich FB kann für die Verbindung der Treiberschaltungen im Randbereich RB und der Logikfunktionen im Kernbereich bzw. für die Anbindung der Versorgungsleitungen im Kernbereich KB verwendet werden. Um den Bereich FB für die Kanäle liegt schließlich ein Randbereich RB, in dem Randzellen RZ angeordnet sind. Die Rand zellen RZ können Treiberschaltungen enthalten oder Anschlußschaltungen.

Die Anordnung der Grundzellen nach Fig. 5 ist derart, daß eine Matrix aus Zeilen von Grundzellen und Spalten von Grundzellen entsteht. Durch die spiegelbildliche Anordnung der Grundzellen werden jeweils zwei Grundzellenzeilen von einer VDD bzw. VSS Versorgungsleitung versorgt. Die Verdrahtung der Grundzellen erfolgt entweder über die Zellen hinweg oder durch Nutzung einer Grundzellenreihe als Verdrahtungskanal, wobei diese Reihe dann nicht für die Realisierung einer Funktion verwendet werden kann. Die Verdrahtung ist in Fig. 5 nicht dargestellt.

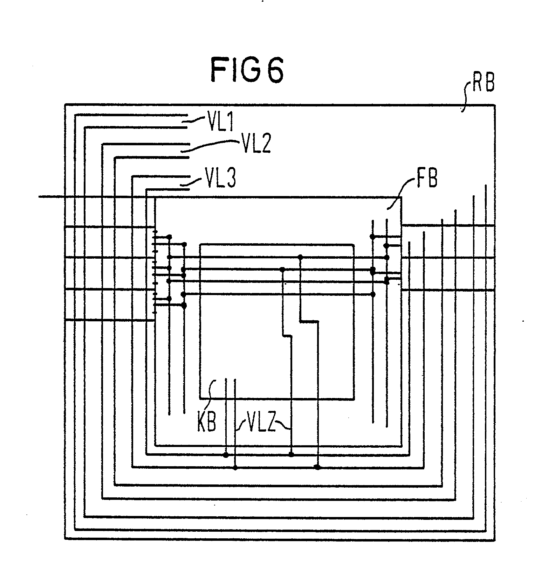

Die Anordnung der Versorgungsleitungen zu den einzelnen Bereichen der Gate Array Anordnung stellt Fig. 6 dar. Im Randbereich RB liegen Versorgungsleitungen VL für das Versorgungspotential VDD bzw. VSS. Diese Versorgungsleitungen VL sind um den Bereich KB für die Kanäle herumgelegt. Es sind Versorgungsleitungen VL1 für die Versorgungspotentiale VDD und VSS für die Treiberschaltungen in den Randzellen RZ, Versorgungsleitungen VL2 für die Versorgungspotentiale VDD und VSS für die übrigen Schaltungen im Randbereich und Versorgungsleitungen VL3 für die Potentiale VDD und VSS für den Kernbereich vorgesehen. Die ringförmige Anordnung der Versorgungsleitungen VL über den Randzellen RZ hat den Vorteil, daß insbesondere die Anschlüsse der Treibertransistoren in den Randzellen kurz sind. Die Verdrahtung zur Einstellung der Funktion in den Randzellen erfolgt dabei in Metall 1, z.B. AL1, und die Führung der Versorgungsleitungen über den Randzellen in Metall 2, z.B. AL2. Neben den Signalanschlüssen befinden sich an den Innenseiten der Randzellen auch die Anschlüsse für die Versorgungsleitungen des Kernbereichs KB. Da mehr Schienen oder Leitungen im Kernbereich als Anschlüsse im Randbereich vorhanden sind, werden die horizontalen Leitungen des Kernbe reiches (ausgeführt z.B. in AL1) durch vertikale Leitungen am Rand des Kernbereichs (ausgeführt z.B.in AL2) zusammengefaßt. Die Versorgungsleitungen des Kernbereiches werden von zwei Seiten angeschlossen. Durch die spiegelbildliche Anordnung der Grundzellen werden jeweils zwei Grundzellenreihen von einer VDD bzw. VSS Leitung versorgt. Sollten im Kernbereich KB weitere Leitungen für Versorgungspotentiale benötigt werden, dann kann dies über vertikal gelegte zusätzliche Versorgungsleitungen VLZ erreicht werden.

Die ringförmige Anordnung der Versorgungsleitungen um den Kernbereich herum hat den Vorteil, daß im Bereich FB für die Verdrahtungskanäle die Verbindung der Versorgungsleitungen im Kernbereich KB mit den Versorgungsleitungen im Randbereich RB auf kürzestem Wege erfolgt und im Kanalbereich FB keine komplizierte Leitungsführung erforderlich ist.

## Ansprüche

1. Grundzelle für eine Gate Array Anordnung in CMOS Technik, bei der erste Transistoren des einen Leitungstyps in einem ersten Bereich hintereinander liegen und gleich viele zweite Transistoren des anderen Leitungstyps in einem zweiten zum ersten Bereich benachbart angeordneten Bereich hintereinanderliegen und bei der die Elektroden der Transistoren im ersten Bereich und die Elektroden der Transistoren im zweiten Bereich jeweils in einer Richtung verlaufen, **gekennzeichnet** durch die folgenden Merkmale:

a) die Anschlüsse (GTA) der Gateelektroden (GT1, GT2) liegen zwischen dem ersten Bereich (BE1) und dem zweiten Bereich (BE2) bzw. an den benachbart liegenden Rändern der beiden Bereiche (BE1, BE2),

b) eine Leitung für das erste Versorgungspotential (VDD) ist am äußeren Rand des ersten Bereiches (BE1) so angeordnet, daß sie in Richtung der hintereinanderliegenden ersten Transistoren (TR1) verläuft,

c) eine Leitung für das zweite Versorgungspotential (VSS) ist am äußeren Rand des zweiten Bereiches (BE2) so angeordnet, daß sie in Richtung der hintereinanderliegenden zweiten Transistoren (TR2) verläuft.

2. Grundzelle nach Anspruch 1, dadurch **gekennzeichnet,** daß ein dritter Transistor (TR3) des anderen Leitungstyps vorgesehen ist, der außerhalb des zweiten Bereiches (BE2) angeordnet ist, dessen Gateelektrode (GT3) parallel zu den Gateelektroden (GT2) der zweiten Transistoren (TR2) verläuft, jedoch kürzer ist als die Gateelektroden (GT2) der zweiten Transistoren (TR2).

3. Grundzelle nach Anspruch 2, dadurch **gekennzeichnet,** daß der Anschluß (GTB) der Gateelektrode (GT3) des dritten Transistors (TR3) benachbart zur Leitung für das zweite Versorgungspotential (VSS) liegt.

4. Grundzelle nach einem der vorhergehenden Ansprüche, dadurch **gekennzeichnet,** daß die Gateanschlüsse (GTA) jeweils eines ersten Transistors und eines zweiten Transistors miteinander verbunden sind.

5. Grundzelle nach einem der vorhergehenden Ansprüche, dadurch **gekennzeichnet,** daß außerhalb des ersten Bereiches parallel zu den Elektroden der ersten Transistoren (TR1) verlaufend ein Substratkontakt (SKT) angeordnet ist.

6. Grundzelle nach einem der vorhergehenden Ansprüche, dadurch **gekennzeichnet,** daß außerhalb des zweiten Bereiches (BE2) parallel zu den Elektroden der zweiten Transistoren (TR2) verlaufend ein Wannenkontakt (WKT) angeordnet ist, der nahe an den Gateanschluß (GTP) des dritten Transistors (TR3) heranragt.

7. Grundzelle nach einem der vorhergehenden Ansprüche, dadurch **gekennzeichnet,** daß die ersten Transistoren (TR1) P-Kanaltransistoren, die zweiten Transistoren (TR2) N-Kanaltransistoren sind und daß die ersten und zweiten Transistoren gleiche Kanalweite haben.

8. Grundzelle nach einem der Ansprüche 2 bis 7, dadurch **gekennzeichnet,** daß der dritte Transistor (TR3) ein N-Kanaltransistor ist, der eine im Vergleich zu den ersten und zweiten Transistoren (TR1, TR2) kleinere Kanalweite hat.

9. Gate Array Anordnung unter Verwendung von Grundzellen nach einem der Ansprüche 1 bis 8, dadurch **gekennzeichnet,** daß

a) ein Kernbereich (KB) aus Grundzellen vorgesehen ist, die matrixartig in Zeilen und Spalten angeordnet sind, wobei zwei benachbart liegende Zeilen aus Grundzellen spiegelbildlich liegen und die Leitung für das Versorgungspotential gemeinsam verwenden,

b) um den Kernbereich ein Kanalbereich (FB) für Verbindungsleitungen gelegt ist,

c) um den Kanalbereich (FB) ein Bereich (RB) für Randzellen (RZ) gelegt ist, in dem auch die äußeren Anschlüsse angeordnet sind.

10. Gate Array Anordnung nach Anspruch 9, dadurch**gekennzeichnet,** daß im Bereich (RB) für die Randzellen (RZ) um den Kanalbereich (FB) herum Versorungsleitungen (VL) angeordnet sind, jeweils zwei Versorgungsleitungen (VSS, VDD) für Treiberschaltungen in den Randzellen (RZ), für die übrigen Schaltungen in den Randzellen und für die Zellen des Kernbereiches.

## FIG 1

## FIG 3

# FIG 2

## FIG 4

RZ

RB

FB

KB

## FIG 5

VSS

VDD

VSS

# FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ELECTRONICS AND COMMUNICATIONS IN JAPAN, Band 66-C, Nr. 1, Januar 1983, Seiten 111-119, Scripta Publishing Co., Silver Spring, Maryland, US; M. ASANO et al.: "Design of CMOS masterslice logic LSI" * Seiten 112-114, Figuren 1,2: "2.3 Basic cell" * | 1,4,7 | H 01 L  27/02 H 01 L  23/52 |
| A | IDEM --- | 5,6,9, 10 | |
| X | DE-A-3 238 311  (SIEMENS AG) * Figur 2; Seite 12, Zeile 33 - Seite 13 * --- | 1,4,7 | |
| X | PATENT ABSTRACTS OF JAPAN, Band 9, Nr. 15 (E-291)[1738], 22. Januar 1985; & JP-A-59 163 837 (TOSHIBA K.K.) 14-09-1984 * Zusammenfassung * | 1,4,7 | |
| A | IDEM --- | 5,6,9 | **RECHERCHIERTE SACHGEBIETE (Int. Cl.4)** H 01 L |
| A | ELECTRONICS INTERNATIONAL, Band 56, Nr. 3, 10. Februar 1983, Seiten 86,87, New York, US; "Gate array needs fewer gates for RAM" * Seite 86, Figur * ----- | 1-4,7,8 | |

Der vorliegende Recherchenbericht wurde für alle Patentansprüche erstellt

| Recherchenort | Abschlußdatum der Recherche | Prüfer |
|---|---|---|
| DEN HAAG | 28-04-1988 | CARDON A. |